(19) Europäisches Patentamt
European Patent Office
Office européen des brevets

(11) EP 0 556 697 B1

(12) **EUROPÄISCHE PATENTSCHRIFT**

(45) Veröffentlichungstag und Bekanntmachung des Hinweises auf die Patenterteilung:
**24.04.1996  Patentblatt 1996/17**

(51) Int Cl.6: **H03M 5/18**, H04L 25/49

(21) Anmeldenummer: **93102010.1**

(22) Anmeldetag: **09.02.1993**

(54) **Verfahren und Anordnung zur Übertragung von Zusatzinformation**

Method and device for the transmission of additional information

Méthode et dispositif de transmission d'information auxiliaire

(84) Benannte Vertragsstaaten:
**DE FR IT**

(30) Priorität: **19.02.1992  DE 4205031**

(43) Veröffentlichungstag der Anmeldung:
**25.08.1993   Patentblatt 1993/34**

(73) Patentinhaber: **SIEMENS AKTIENGESELLSCHAFT
D-80333 München (DE)**

(72) Erfinder:
- **Drügh, Paul, Dipl.-Phys.
  W-8000 München 71 (DE)**
- **Schug, Windfried, Dipl.-Ing.
  W-8000 München 83 (DE)**
- **Fellner, Richard, Dipl.-Ing.
  W-8000 München 19 (DE)**

(56) Entgegenhaltungen:
**EP-A- 0 090 728          EP-A- 0 204 376
EP-A- 0 443 712**

Printed by Jouve, 75001 PARIS (FR)

**Beschreibung**

Die Erfindung betrifft ein Verfahren nach dem Oberbegriff des Patentanspruchs 1. In unabhängigen Patentansprüchen sind eine sende- und eine empfangsseitige Anordnung zur Durchführung des Verfahrens angegeben.

Binäre Daten werden häufig in Ternärwerte umcodiert übertragen. Hierzu wird beispielsweise der AMI-Code verwendet, bei dem abwechselnd für eine logische "1" ein positiver und ein negativer Spannungswert ausgesendet wird. Eine Weiterentwicklung dieses Codes ist der HDB-3-Code, bei dem Nullfolgen mit mehr als drei Nullen vermieden werden. Dieser Code ist ebenso wie der AMI-Code gleichstromfrei; er liefert darüber hinaus auch eine ausreichende Zahl von Schrittumschlägen für die empfangsseitige Synchronisierung. Der pseudoternäre HDB-3-Code wird beispielsweise beim Pulscodemodulation-Übertragungssystem PCM-30 eingesetzt (Siemens Sonderdruck Zeitmultiplex-System PCM-30F, Best. Nr. S42023-A734-Al-I-29). Die Zwischenregeneratoren auf der Übertragungsstrecke und die Empfangseinrichtungen sind speziell für diesen Code optimiert. Die Übertragungsbitrate ist ebenfalls festgelegt.

Die EP-A-0 443 712 zeigt ein modifiziertes HDB3 system, das die Übertragung von Zusatzinformationen ermöglicht.

Für verschiedene Aufgaben ist die Übertragung von Zusatzinformation erforderlich, ohne daß die Schrittgeschwindigkeit erhöht wird oder spezielle Anpassungen der Übertragungseinrichtung vorgenommen werden müssen.

Dieses Problem wird durch das im Patentanspruch 1 angegebene Verfahren gelöst. Geeignete Anordnungen zur Durchführung des Verfahrens sind in den Unteransprüchen angegeben.

Vorteilhafte Weiterbildungen der Erfindung sind in den Unteransprüchen angegeben.

Vorteilhaft bei diesem Verfahren ist es, daß Zusatzinformation mit einer relativ hohen Bitrate übertragen werden kann, ohne daß sich das Spektrum des verwendeten Übertragungscodes wesentlich vom bisher verwendeten Code unterscheidet. Ein wesentlicher Vorteil liegt darin, daß ein Ternärcode mit einer relativ kurzen Wortlänge verwendet wird, so daß der Schaltungsaufwand für die Umcodierung akzeptabel ist.

Durch die zusätzliche Übertragungskapazität kann sowohl ein Dienstkanal realisiert werden als auch zusätzliche Datenkanäle zur Verfügung gestellt werden. Ebenso ist auch die Netzung der Zusatzinformation zur Fehlerkorrektur möglich.

Bei der sendeseitigen und der empfangsseitigen Anordnung wird der Speicheraufwand durch eine "Umpolungseinrichtung" halbiert.

Die Erfindung wird anhand von Figuren näher erläutert.

Es zeigen:

Fig. 1 ein Prinzipschaltbild einer geeigneten Anordnung,
Fig. 2 eine sendeseitige Anordnung,
Fig. 3 eine empfangsseitige Anordnung und
Fig. 4 eine Decodiereinrichtung.

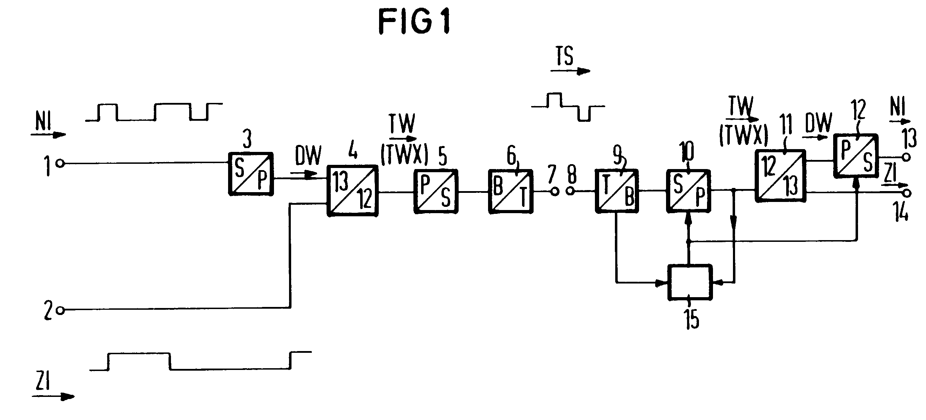

Die in Figur 1 dargestellte Übertragungsanordnung besteht sendeseitig aus der Kettenschaltung eines ersten Seriell-Parallel-Umsetzers 3, dem über einen ersten Eingang 1 die Nutzinformation NI zugeführt wird. Dies ist bei dem PCM-30-System das zu übertragene Multiplexsignal. Nach der Seriell-Parallel-Umwandlung werden jeweils 12 Bits Nutzinformation NI durch 1 Bit der Zusatzinformation ZI ergänzt und das so gewonnene 13-bit-Datenwort dem Eingang eines Binär/Ternär-Codeumsetzers 4 zugeführt. Dieser gibt an seinem Ausgang ein 12-tit-Ternärwort TW (tit= ternary digit/Ternärsymbol/Ternärwert) bzw. ein auszusendendes Ternärwort TWX (auf das später eingegangen wird) ab, das von einem Parallel-Seriell-Umsetzer 5 wiederum in serielle Information umgesetzt wird, die durch den Binär/Ternär-Wandler 6 in ein Ternärsignal TS umgesetzt werden, das er an seinem Datenausgang 7 an eine geeignete Übertragungseinrichtung abgibt.

Die empfangsseitige Anordnung besteht aus der Kettenschaltung eines Ternär/Binär-Wandlers 9, eines zweiten Seriell/Parallel-Umsetzers 10, eines Ternär/Binär-Codeumsetzers 11 und eines zweiten Parallel/Seriell-Wandlers 12.

Dem Dateneingang 8 des Ternär/Binär-Wandlers 9 wird das übertragene Ternärsignal TS zugeführt und in binäre Daten umgesetzt. Der zweite Seriell/Parallel-Wandler 10 bewirkt die Rückumsetzung in binär dargestellte parallele 12-tit-Ternärwörter TW. Diese werden einem Ternär/Binär-Codeumsetzer 11 zugeführt und in die binären 13-bit-Datenwörter DW rückübersetzt. Die 12 Bits Nutzinformation des Datenwortes DW werden durch einen zweiten Parallel/Seriell-Umsetzer 12 wieder in serielle Nutzinformation NI rückumgesetzt und am ersten Ausgang 13 abgegeben. Jeweils ein Bit Zusatzinformation ZI wird am zweiten Ausgang 14 des Ternär/Binär-Codeumsetzers 11 abgegeben. Eine Synchronisationseinrichtung 15 überwacht die vorgegebenen Coderegeln nach dem Ausgang des Seriell/Parallel-Umsetzers 10 und variiert die Arbeitstakte zu Beginn der Übertragung solange, bis der Synchronismus hergestellt ist, d.h. bis die korrekten Wortgrenzen für die übertragenen Ternärsignale gefunden sind.

Bevor auf weitere Einzelheiten der Anordnung eingegangen wird, soll zunächst die Codierung näher erläutert werden. Ein Binärcode mit n Bits je Wort weist einen Codeumfang von $2^n$ Wörtern auf. Ein Ternärcode mit n Tits (ternary digits) je Wort weist einen größeren Codeumfang von $3^n$ Codewörtern auf. Bei ternärer Codierung eines binären Signals ist deshalb die Übertragung zusätzlicher Information bei der gleichen Schrittgeschwindigkeit möglich. Das Verhältnis der Anzahl der Codewörter eines Ternärcodes zu den Codewörtern eines Binärcodes vergrößert sich bei zunehmender Wortlänge immer weiter zugunsten des Ternärcodes. Mit zunehmender Wortlänge wird daher die Übertragung eines zunehmenden Anteils von Zusatzinformation möglich. Der Schaltungsaufwand für die Codierung und die Umcodierung steigt jedoch mit der Wortlänge exponentiell an. Außerdem müssen bestimmte Bedingungen für den Übertragungscode eingehalten werden. Es gilt daher, einen Kompromiß zwischen dem Schaltungsaufwand und der maximalen Datenrate für die Übertragung der Zusatzinformation zu finden, bei der der Schaltungsaufwand noch vertretbar ist. Die Datenrate des Zusatzsignals soll 1/12 der Datenrate des Nutzsignals betragen.

Als Umwandlungsvorschrift zur Umsetzung der binären Daten in ternäre Daten gilt:

$$A_i = -1 + INT\ (d/c_i - 1)\ -3 * INT\ (d/c_i)$$

dabei entspricht:

d = umzuwandelnde Dezimalzahl,
i = Index (1, 2, ... 12),
$c_i$ = 3 exp i,
$A_i$(A1 ... A12) = Ternärwerte,

wobei die Binärkombination zunächst in die Dezimalzahl umgerechnet wird.

Von den möglichen $3^{12}$ Ternärwörtern wurden $2^{13} = 8.192$ ausgewählt, die folgende Bedingungen aufweisen:

a) Wortsumme WS = 0 und erster Ternärwert A1 = 1 oder 0 (WS = A1+A2+ ...+A12) oder
b) Wortsumme WS = +1 und A1 = 0,
c) keine zwei aufeinanderfolgenden Ternärwerte gleicher Polarität (+1, +1 oder -1, -1),
d) keine Folgen von mehr als zwei Ternärwerten "0" am Wortanfang oder Wortende, bzw. mehr als vier Ternörwerten "0" im Wort,
e) keine +10+10+1- bzw. -10-10-1- Folgen am Wortanfang keine +10+10- bzw. 10-10 oder x+10+10- bzw. x-10-10- Folgen (x = beliebiger Ternärwert)

Entsprechende Folgen am Wortende werden soweit wie möglich ebenfalls vermieden.

Die Betrachtungen über die Wortsumme gehen davon aus, daß den Ternärwerten die Ziffern -1,0,+1 zugeordnet werden. Auf die übertragenen Spannungswerte bezogen entspricht die Wortsumme WS = 0 derselben Anzahl von "ersten" und "dritten" Ternärwerten "-1" und "+1", also der Gleichstromfreiheit, eine Abweichung der laufenden Wortsumme um +1 oder -1 entspricht einem Ungleichgewicht von einem Ternärwert, "+1" bzw. "-1". Der mittlere Ternärwert "0" entspricht dem Bezugspotential, in der Regel 0 Volt.

Natürlich können die binären Einsen mit den binären Nullen und die Ternärwerte "+1" mit den Ternärwerten "-1" vertauscht werden, ohne daß sich an der Codierung eine prinzipielle Änderung ergibt. Die Zuordnung von Ternärwerten "+1" und "-1" zu den oberen oder unteren Spannungswerten ist rein willkürlich.

Die Bedingungen c) bis e) ermöglichen bei Zwischenregeneratoren und Leitungsendgeräten eine problemlose Taktrückgewinnung.

Die Bedingungen a) und b) ermöglichen eine gleichstromfreie Übertragung, indem die laufende Wortsumme LWS = $WS_1 + WS_2 + ... + WS_k + WS_{k+1}$ ... der aufeinanderfolgenden (zu) übertragenen Ternärwörter TWX in den erlaubten Grenzen - 1, 0, + 1 bleibt. Dies wird durch Invertieren von Ternärwörtern TW mit der Wortsumme WS = 1 erreicht. Die zu übertragenen Ternärwörter TWX entsprechen somit nichtinvertierten und invertierten Ternärwörtern TW.

Darüber hinaus kann unter Einhaltung der vorstehenden Bedingung auch invertiert werden, um zu vermeiden, daß aufeinanderfolgende Einsen gleicher Polarität durch aneinanderfügen der Ternärwörter entstehen, beispielsweise wenn das letzte Bit ungleich 0 des vorangegangenen Ternärwortes TWK und das erste Bit des folgenden Ternärwortes mit demselben Ternärwert beginnt.

$$1\ 0\ 0\ -1\ 0\ 1\ -1\ 0\ 1\ 0\ -1\ 1\quad |\quad 1\ -1\ 0\ 0\ 1\ -1\ 0\ 0\ 0\ 1\ -1\ 0$$
$$TW_k \hspace{5cm} TW_{k+1}$$
$$(1\ =\ +1)$$

Von den ausgewählten Ternärwörtern haben ca. 6000 die Wortsumme WS = 0. Diese Wörter sind problemlos aneinanderzureihen und zu invertieren, ohne daß sich die laufende Wortsumme LWS verändert. Ist dagegen die laufende Wortsumme bereits ungleich Null, z.B. +1, wird das nächstfolgende Wort, das die Wortsumme WS = +1 aufweist, invertiert. Dadurch wird dessen Wortsumme WS = -1 und die laufende Wortsumme LWS = 0, d.h. der Gleichspannungsanteil geht auf Null zurück. Unter Invertieren eines Wortes wird der Polaritätswechsel der Ternärwerte (genauer der entsprechenden Spannungszustände) verstanden, die Einsen repräsentieren. Um Ternärwörter binär darstellen zu können, wird das Ternärwort in einen P-Anteil PA und einen N-Anteil NA zerlegt.

```
                    nicht  invertiert              |      invertiert
        _____

Ternärwort    0+1 0-1+1 0 0+1 0-1 0-1    |0-1 0+1-1 0 0-1 0+1 0+1
        -------------------------------------------|----------------------------

P-Anteil      0 1 0 0 1 0 0 1 0 0 0 0    |0 0 0 1 0 0 0 0 0 1 0 1
              P1 P2 ......          P12

N-Anteil      0 0 0 1 0 0 0 0 0 1 0 1    |0 1 0 0 1 0 0 1 0 0 0 0
              N1 N2 ......          N12
```

Beim Invertieren werden P-Anteil mit N-Anteil vertauscht. Durch die P- und N-Anteile wird das Vorzeichen der ternären Bits bestimmt, so daß eine Invertierung der P- und N-Anteile einem Wechsel der Polarität auf der Übertragungsstrecke entspricht.

Es soll jetzt noch einmal genauer auf das Invertieren der Ternärwörter $TW_{k+1}$ eingegangen werden, das den Zweck hat, an den Wortgrenzen oder in deren Nähe Zwei gleiche aufeinanderfolgende Ternärwerte ‡ 0 zu vermeiden. Bei einem folgenden Ternärwort mit der Wortsumme WS = 0 können die P- und N-Anteile stets invertiert werden, ohne daß sich die Wortsumme WS und damit die laufende Wortsumme LWS ändert. Ist die Wortsumme des folgenden Ternärwortes Null, so kann es unabhängig von der laufenden Wortsumme nichtinvertiert oder invertiert angefügt werden.

Ist die laufende Wortsumme dagegen +1 oder -1 so muß das folgende Ternärwort mit einer Wortsumme +1 in bestimmter Weise hinzugefügt werden.

Deshalb ist der erste Ternärwert A1 = 0, so daß keine zwei gleiche Ternärwerte +1, +1 oder -1, -1 aneinanderstoßen.

Zur Vereinfachung kann die laufende Wortsumme auf 0 und +1 beschränkt werden, und die Invertierungsbedingungen IB können auf das letzte Tit A12 des vorangegangenen Ternärworts und das erste Bit bei Ternärwörtern mit der Wortsumme WS = 0 bzw. auf das zweite Bit bei der Wortsumme WS=1 bei Ternärwörtern mit der Wortsumme 1 reduziert werden.

## Invertieren

```
              TW_k                           TW_{k+1}
          LWS = -1,0,+1                       WS = 0

    IB1)      A12 = 1           =            A1


              LWS = 0           =            WS = 1 (A1 = 0)


    IB2)      A12 ‡ 0           =            A2    (fakultativ)


    IB3)      LWS = +1          =            WS = 1
```

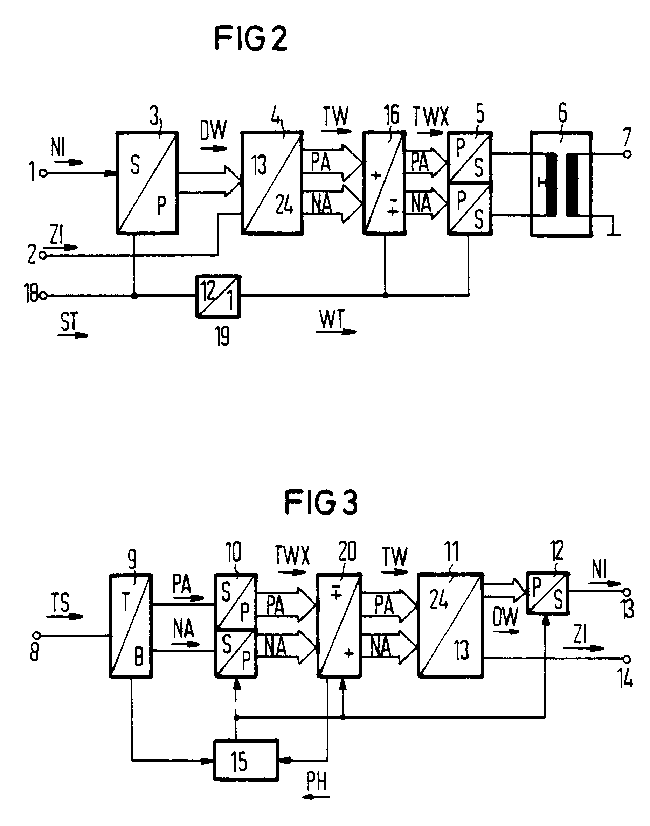

In Figur 2 ist ein erweitertes Prinzipschaltbild der sendeseitigen Anordnung dargestellt. Es beinhaltet den aus der Kettenschaltung des aus Figur 1 bekannten ersten Seriell/Parallel-Umsetzers 3, den Binär/Ternär-Codeumsetzer 4, einen Invertiereinrichtung 16, den ersten Parallel-Seriell-Umsetzer 5 und den Binär/Ternär-Wandlers 6. Über einen Taktanschluß 18 wird ein Systemtakt ST dem Seriell/Parallel-Umsetzer 3 zugeführt. Aus dem Systemtakt wird durch einen Frequenzteiler 19 der Worttakt WT gebildet, der das Hinzufügen eines Bits der Zusatzinformation und vor allen Dingen die Invertierungseinrichtung 16 taktmäßig steuert.

Die Funktion entspricht im wesentlichen der des Prinzipschaltbildes aus Figur 1. Da zur Darstellung der drei Ternärwerte zwei Bits erforderlich sind, werden die Positiv-Anteile PA und die Negativ-Anteile NA eines Ternärwortes TW bereits am Ausgang des Binär/Ternär-Codeumsetzers 4 als zwei 12 bit-Anteile PA und NA abgegeben und der Invertierungseinrichtung 16 zugeführt. Diese verfügt über die notwendigen Prüfeinrichtungen, um die Wortsumme WS festzustellen (dies kann auch vom Binär/Ternär-Codeumsetzer ausgegeben werden) und hat ein Gedächtnis für die laufende Wortsumme LWS sowie das letzte Tit A12 = P12, N12 (oder die letzten Tits) des vorangegangenen Ternärwortes $TW_k$. Sie veranlaßt durch eine Gatterlogik auch gegebenenfalls eine Vertauschung der Positiv-Anteile PA mit den Negativanteilen PN. Diese Anteile repräsentieren die ausgesendeten Ternärwörter TWX, sie werden in serielle Daten umgesetzt, die den Binär/Ternär-Wandler 6 in bekannter Weise ansteuern, um in bekannter Weise am Datenausgang 7 das Ternärsignal TS zu erzeugen. Die Funktion der Invertierungseinrichtung kann natürlich von einem erweiterten BIT-Codeumsetzer mitübernommen werden.

Ergänzend soll noch hinzugefügt werden, daß es sendeseitig genügt, die Parität der Positiv-Anteile und Negativ-Anteile zu ermitteln, da durch die Auswahl der Ternärwörter bereits festgelegt ist, daß die Wortsumme 0 oder +1 beträgt. Auch die Wortsumme kann von einem erweiterten Binär/Ternär-Codeumsetzer ausgegeben werden.

In Figur 3 ist eine empfangsseitige Anordnung zur Rückumsetzung des Ternärsignals in binäre Daten dargestellt. Sie enthält die Kettenschaltung des Ternär/Binär-Wandlers 9, den Seriell-Parallel-Umsetzers 10, einer zweiten Invertierungseinrichtung 20, den Ternär/Binär-Codeumsetzers 11 und den Parallel/Seriell-Umsetzers 12.

Dem Dateneingang 8 des Ternär/Binär-Wandlers 9 wird das serielle Ternärsignal TS zugeführt. Dieser setzt es zunächst in serielle Binärdaten um, die bereits nach dem Positiv-Anteil PA und dem Negativ-Anteil NA getrennt sind. Diese werden in dem Seriell/Parallel-Umsetzer 10 in zwei parallele 12-bit-Anteile PA und NA umgesetzt, die den ausgesendeten Ternärwörtern TWX entsprechen und der zweiten Invertierungseinrichtung 20 zugeführt werden.

Diese macht die sendeseitige Invertierung aufgrund derselben Invertierungsbedingungen rückgängig, so daß das ursprüngliche Ternärwort TW - aufgeteilt in positive Anteile PA und negative Anteile NA - an den Eingang des Ternär/Binär-Wandlers 11 anliegt. Dieser Wandler kann als Speicher oder Gatterlogik aufgebaut sein. Ihm werden als Adresse 24 Bits zugeführt, die dem 12-tit-Ternärwort TW entsprechen. Am Ausgang wird wieder ein 13-bit-Datenwort DW abgegeben, ein Bit hiervon ist Zusatzinformation ZI, die am zweiten Ausgang 14 abgegeben wird. Die Nutzinformation NI wird nach der Umsetzung durch den Parallel/Seriell-Umsetzer 12 als serielles Signal am ersten Ausgang 13 abgegeben. Auf der Empfangsseite wird zur Synchronisierung überprüft, ob die Wortsumme -1,0 oder +1 beträgt. Dies kann mittels eines Binärzählers erfolgen oder durch den Ternär/Bi när-Codeumsetzer 11 festgestellt werden, der dann ein entsprechendes Signal an die zweite Invertierungseinrichtung 20 und die Synchronisierung 15 abgibt.

Die Synchronisierung 15 erhält sowohl Schrittumschläge zur Bitsynchronisierung als auch ein Kriterium PH, das angibt, ob die Wortgrenzen stimmen, von der zweiten Invertierungseinrichtung 20 oder vom Ternär/Binär-Wandler. Die Worttakte WT werden spätestens in der zweiten Invertierungseinrichtung 20 und beim Parallel/Seriell-Umsetzer 12 benötigt.

Wird der Ternär/Binär-Codeumsetzer 11 mit Hilfe eines Speichers realisiert, so werden 24 Adresseneingänge benötigt. Bei einer 13-bit-Wortbreite entspricht dies einem Speicher von 218 Mbit. Außerdem kann jeweils noch ein Datenausgang zum Signalisieren gültiger Kombinationen verwendet werden. Andererseits werden nur 8.192 Datenwörter von jeweils 13 Bits Länge, das sind 106 kbit, verwendet. Durch eine Selekt-Logikschaltung soll die Anzahl der Adresseneingänge reduziert werden.

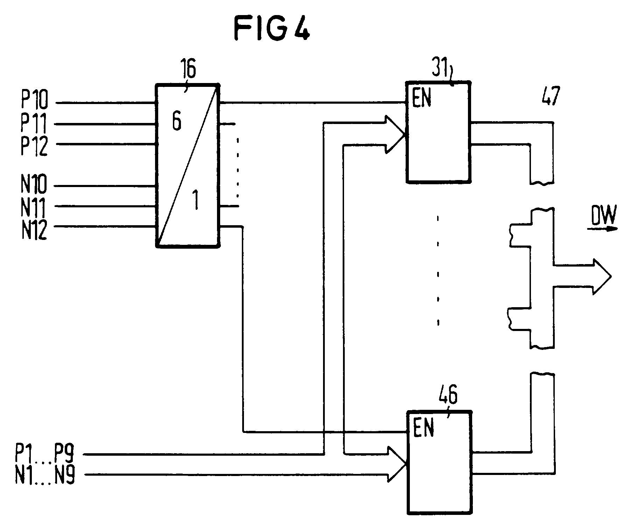

In Figur 4 ist eine entsprechende Anordnung aufgebaut. Der Selekt-Logikschaltung 21 werden beispielsweise die drei niederwertigen Bits P10 bis P12 bzw. N10 bis N12 des Positiv-Anteils PA und des Negativ-Anteils NA eines Ternärwortes TW zugeführt. Die Selektlogik weist 16 Ausgänge auf, die mit Enable-Eingängen EN von 16 Speicherbausteinen 31 bis 46 verbunden sind, deren Ausgänge wiederum über eine WIRED-OR-Schaltung 47 zusammengefaßt sind. Durch die sechs Anteilbits P10 bis P12 und N10 bis N12 ergeben sich nur 16 verschiedene Binärkombinationen.

| mögliche Kombinationen: | P12 | P11 | P10 | N12 | N11 | N10 |
|---|---|---|---|---|---|---|
| | 0 | 0 | 0 | 0 | 0 | 1 |
| | 0 | 0 | 0 | 0 | 1 | 0 |
| | 0 | 0 | 0 | 1 | 0 | 0 |
| | 0 | 0 | 0 | 1 | 0 | 1 |
| | 0 | 0 | 1 | 0 | 0 | 0 |
| | 0 | 0 | 1 | 0 | 1 | 0 |
| | 0 | 0 | 1 | 1 | 0 | 0 |
| | 0 | 1 | 0 | 0 | 0 | 0 |

| | | | | | |
|---|---|---|---|---|---|
| 0 | 1 | 0 | 0 | 0 | 1 |
| 0 | 1 | 0 | 1 | 0 | 0 |
| 0 | 1 | 0 | 1 | 0 | 1 |
| 1 | 0 | 0 | 0 | 0 | 0 |
| 1 | 0 | 0 | 0 | 0 | 1 |
| 1 | 0 | 0 | 0 | 1 | 0 |
| 1 | 0 | 1 | 0 | 0 | 0 |
| 1 | 0 | 1 | 0 | 1 | 0 |

So kann eine Stelle eines Ternärwortes nicht gleichzeitig eine "+1" in dem Positiv-Anteil PA und eine "-1" im Negativ-Anteil NA bewirken. Weiter ist die Anzahl der möglichen Kombinationen durch die Code-Regeln begrenzt (z.B. keine 2 positiven oder negativen Einsen in Folge). Durch die 16 Kombinationen wird jeweils ein Speicherbaustein mit 18 Eingängen angesteuert und ein binäres 13-bit-Datenwort DW aufgerufen. Die Selektlogik kann auch komplizierter gestaltet werden, um Speicherbausteine mit geringerem Adressenumfang einsetzen zu können.

**Patentansprüche**

1. Verfahren zur Übertragung von Zusatzinformation (ZI) über einen ternären Datenkanal, in dem ternär codierte Nutzinformation (NI) übertragen wird, die empfangsseitig in binäre Nutzinformation (NI) rückumgesetzt wird,

   **dadurch gekennzeichnet,**
   daß jeweils 12 Bits Nutzinformation (NI) mit einem Bit Zusatzinformation (ZI) zu einem 13-bit-Datenwort (DW) zusammengefaßt werden,
   daß jeweils ein binäres 13-bit-Datenwort in ein 12-tit-Ternärwort (TW) umgesetzt wird, das

   a) eine Wortsumme (WS) seiner Ternärwerte (-1, 0, +1) von 0 aufweist und als erstes Tit (A1) den Ternärwert "0" oder "+1" aufweist oder
   b) eine Wortsumme (WS) von +1 aufweist, wenn das erste Tit (A1) des Ternärwortes "0" ist,

   daß die laufende Wortsumme (LWS) übertragener Ternärwörter (TWX) im Bereich -1, 0, +1 liegt und
   daß empfangsseitig nach der Rückumsetzung der Ternärwörter (TW) in binäre Datenwörter (DW), diese in Nutzinformation (NI) und Zusatzinformation (ZI) aufgeteilt werden.

2. Verfahren nach Anspruch 1,

   **dadurch gekennzeichnet,**
   daß die laufende Wortsumme (LWS) der übertragenen Ternärwörter (TWX) durch Umpolung der "+1" und "-1" Ternärwerte eines folgenden Ternärwortes (TW$_{k+1}$), das eine Wortsumme WS = +1 aufweist, im Bereich -1 bis +1 gehalten wird.

3. Verfahren nach Anspruch 1,

   **dadurch gekennzeichnet,**
   daß die laufende Wortsumme (LWS) durch Umpolung der "+1"- und "-1"-Ternärwerte des folgenden Ternärwortes (TW$_{k+1}$), das eine Wortsumme WS = +1 aufweist, im Bereich 0,+1 gehalten wird.

4. Verfahren nach einem der vorhergehenden Ansprüche,
   **dadurch gekennzeichnet,**

   c) daß das Ternärwort (TW) keine Folgen von mehr als vier mittleren Ternärwerten "0" aufweist oder am Wortanfang und oder am Wortende keine Folgen von mehr als zwei Ternärwerten "0" aufweist.

5. Verfahren nach Anspruch 1 oder 2,

**dadurch gekennzeichnet,** daß

d) keine zwei aufeinanderfolgende Ternärwerte +1, +1 oder -1, -1 auftreten.

6. Verfahren nach einem der vorhergehenden Ansprüche,

**dadurch gekennzeichnet,**

daß bei jedem Ternärwort (TW)

e) die Anzahl der Ternärwerte "+1" und "-1" in einem Ternärwort (TW) größer als 2 ist,

f) keine +1, 0, +1, 0,+1-Folgen und keine -1, 0, -1, 0, -1-Folgen von Ternärwerten auftreten und

g) am Wortanfang keine +1, 0, +1, 0-Folgen oder -1, 0, -1, 0-Folgen und keine x,+1, 0, +1, 0-Folgen oder x, -1, 0, -1, 0-Folgen auftreten (x = -1, 0, +1).

7. Verfahren nach einem der vorhergehenden Ansprüche,

**dadurch gekennzeichnet,**

daß eine Invertierung der Ternärwerte "+1" und "-1" erfolgt, wenn der letzte Ternärwert ( ..., A11, A12) ungleich "0" des vorhergehenden Ternärwortes ($TW_k$) und der erste Ternärwert (A1, A2, ...) ungleich "0" des folgenden Ternärwortes ($TW_{k+1}$) dieselbe Polarität aufweisen.

8. Verfahren nach Anspruch 7,

**dadurch gekennzeichnet,**

daß stets nur der letzte Ternärwert (A13) des vorhergehenden Ternärwortes ($TW_k$) und der erste Ternärwert (A1) des folgenden Ternärwortes ($TW_{k+1}$) bewertet werden.

9. Verfahren nach einem der vorhergehenden Ansprüche,

**dadurch gekennzeichnet,**

daß weitestgehend +1, 0, +1, 0- und -1, 0, -1, 0-Folgen sowie +1, 0, +1, x- und -1, 0, -1, x-Folgen am Wortende vermieden werden.

10. Anordnung zur Übertragung von Zusatzinformation,

**dadurch gekennzeichnet,**

daß sendeseitig ein erster Seriell-Parallel-Umsetzer (3) vorgesehen ist, dem die Nutzinformation (NI) zugeführt wird und der an seinem Ausgang ein 12-bit-Wort abgibt, das durch ein Bit der Zusatzinformation (ZI) zu einem 13-bit-Datenwort (DW) ergänzt wird,

daß ein Binär/Ternär-Codeumsetzer (4) das 13-bit-Datenwort (DW) in einen 12-bit-Positiv-Anteil (PA) und einen 12-bit-Negativ-Anteil (NA) eines Ternärwortes (TW) umsetzt, die einer Invertierungsschaltung (16) zugeführt werden, die in Abhängigkeit einer laufenden Wortsumme (LWS) eine Invertierung des Positiv-Anteils (PA) und des Negativ-Anteils (NA) durchführt,

daß die Positiv-Anteile (PA) und Negativ-Anteile (NA) der zu übertragenden Ternärwörter (TWX) über einen ersten Parallel/Seriell-Umsetzer (5) einem Binär/Ternär-Wandler (6) zur Umsetzung in ein Ternärsignal (TS) zugeführt sind.

11. Anordnung zur Übertragung von Zusatzinformation (ZI) über einen ternären Datenkanal, in dem ternär codierte Nutzinformation (NI) übertragen wird, die empfangsseitig in binäre Nutzinformation (NI) rückumgesetzt wird,

**dadurch gekennzeichnet,**

daß empfangsseitig ein Binär/Ternär-Wandler (9) vorgesehen ist, dem das Ternärsignal (TS) zugeführt wird und der an seinen Ausgängen positiven und negativen Ternärzuständen entsprechende Folgen des Positiv-Anteils (PA) und des Negativ-Anteils (NA) abgibt,

daß ein zweiter Seriell-Parallel-Umsetzer (10) vorgesehen ist, der diese Folgen in parallele vorliegende Positiv-Anteile (PA) und Negativ-Anteile (NA) des übertragenen Ternärwortes (TWX) umsetzt,

daß eine zweite Invertierungseinrichtung (20) vorgesehen ist, die entsprechend den sendeseitigen Invertierungsbedingungen die Positiv-Anteile (PA) und Negativ-Anteile (NA) invertiert und diese einem Ternär/Binär-Codeumsetzer (11) zuführt, der an seinen Ausgängen das rückumgesetzte binäre 13-bit-Datenwort (DW) abgibt, das in Nutzinformation (NI) und Zusatzinformation (ZI) aufgeteilt wird.

**12.** Anordnung nach Anspruch 10,

**dadurch gekennzeichnet,**
daß als Ternär/Binär-Codeumsetzer (11) eine Selekt-Logikschaltung (21) vorgesehen ist, deren Eingängen dieselbe Anzahl gleicherwertiger Bits (P10, P11, P12; N10, N11, N12, A12) des Positiv-Anteils (PA) und des Negativ-Anteils (NA) eines Ternärwortes (TW) zugeführt wird und deren Ausgänge jeweils einen von mehreren (16) Speicherbausteinen (31 bis 46) aktivieren, deren gleichwertige Ausgänge zusammengeschaltet sind.

## Claims

1. Method for transmitting additional information (ZI) over a ternary data channel, in which ternary coded user information (NI) is transmitted which is converted back into binary user information (NI) at the receiving end, characterized

in that in each case 12 bits user information (NI) are combined with one bit additional information (ZI) to form a 13-bit data word (DW),
in that in each case a binary 13-bit data word is converted into a 12-tit ternary word (TW) which

a) has a word sum (WS) of its ternary values (-1, 0, +1) of 0 and has the ternary value "0" or "+1" as the first tit (A1), or
b) has a word sum (WS) of +1 if the first tit (A1) of the ternary word is "0",

in that the running word sum (LWS) of transmitted ternary words (TWX) is in the range -1, 0, +1, and
in that at the receiving end, after the ternary words (TW) have been converted back into binary data words (DW), the latter are split into user information (NI) and additional information (ZI).

2. Method according to Claim 1, characterized in that the running word sum (LWS) of the transmitted ternary words (TWX) is held in the range -1 to +1 by reversing the polarity of the "+1" and "-1" ternary values of a following ternary word ($TW_{k+1}$) which has a word sum WS = +1.

3. Method according to Claim 1, characterized in that the running word sum (LWS) is held in the range 0, +1 by reversing the polarity of the "+1" and "-1" ternary values of the following ternary word ($TW_{k+1}$) which has a word sum WS = +1.

4. Method according to one of the preceding claims, characterized in that

c) the ternary word (TW) has no sequences of more than four middle ternary values "0" or has no sequences of more than two ternary values "0" at the beginning of the word and/or at the end of the word.

5. Method according to Claim 1 or 2, characterized in that

d) no two successive ternary values +1, +1 or -1, -1 occur.

6. Method according to one of the preceding claims, characterized in that for every ternary word (TW)

e) the number of ternary values "+1" and "-1" in a ternary word (TW) is greater than 2,
f) no +1, 0, +1, 0, +1 sequences and no -1, 0, -1, 0, -1 sequences of ternary values occur, and
g) at the beginning of the word no +1, 0, +1, 0 sequences or -1, 0, -1, 0 sequences occur and no x, +1, 0, +1, 0 sequences or x, -1, 0, -1, 0 sequences occur (x = -1, 0, +1).

7. Method according to one of the preceding claims, characterized in that the ternary values "+1" and "-1" are inverted if the last ternary value (..., A11, A12) not equal to "0" of the preceding ternary word ($TW_k$) and the first ternary value (A1, A2, ...) not equal to "0" of the following ternary word ($TW_{k+1}$) have the same polarity.

8. Method according to Claim 7, characterized in that only the last ternary value (A13) of the preceding ternary word

($TW_k$) and the first ternary value (A1) of the following ternary word ($TW_{k+1}$) are ever evaluated.

9. Method according to one of the preceding claims, characterized in that as far as possible +1, 0, +1, 0 and -1, 0, -1, 0 sequences as well as +1, 0, +1, x and -1, 0, -1, x sequences are avoided at the end of a word.

10. Arrangement for transmitting additional information, characterized in that there is provided at the transmitting end a first serial/parallel converter (3) to which the user information (NI) is supplied and which outputs at its output a 12-bit word, which is extended by one bit of additional information (ZI) to form a 13-bit data word (DW), in that a binary/ternary code converter (4) converts the 13-bit data word (DW) into a 12-bit positive part (PA) and a 12-bit negative part (NA) of a ternary word (TW), which is supplied to an inversion circuit (16) that performs an inversion of the positive part (PA) and the negative part (NA) depending on a running word sum (LWS), and in that the positive parts (PA) and negative parts (NA) of the ternary words (TWX) to be transmitted are supplied via a first parallel/serial converter (5) to a binary/ternary converter (6) for conversion into a ternary signal (TS).

11. Arrangement for transmitting additional information (ZI) over a ternary data channel, in which ternary coded user information (NI) is transmitted which is converted back into binary user information (NI) at the receiving end, characterized in that provided at the receiving end is a binary/ternary converter (9) to which the ternary signal (TS) is supplied and which outputs at its outputs sequences of the positive part (PA) and of the negative part (NA) corresponding to positive and negative ternary states, in that a second serial/parallel converter (10) is provided which converts said sequences into parallel positive parts (PA) and negative parts (NA) of the transmitted ternary word (TWX), and in that a second inversion means (20) is provided which inverts the positive parts (PA) and negative parts (NA) in accordance with the inversion conditions at the transmitting end and supplies these to a ternary/binary code converter (11) which outputs at its outputs the converted back binary 13-bit data word (DW), which is split into user information (NI) and additional information (ZI).

12. Arrangement according to Claim 10, characterized in that a select logic circuit (21) is provided as the ternary/binary code converter (11), to the inputs of which circuit the same number of equivalent bits (P10, P11, P12; N10, N11, N12, A12) of the positive part (PA) and of the negative part (NA) of a ternary word (TW) are supplied, and the outputs of which in each case activate one of a plurality (16) of memory modules (31 to 46) whose equivalent outputs are interconnected.

## Revendications

1. Procédé de transmission d'information auxiliaire (ZI) par l'intermédiaire d'un canal de données ternaire, dans lequel on transmet une information utile (NI) à codage ternaire, que l'on reconvertit du côté du récepteur en information utile (NI) binaire, caractérisé en ce que l'on réunit 12 bits d'information utile (NI) à un bit d'information auxiliaire (ZI) pour former un mot de données à 13 bits (DW),

   on convertit un mot de données binaire à 13 bits en un mot ternaire (TW) à 12 tits, qui présente

   a) une somme de mot (WS) de ses valeurs ternaires (-1, 0, +1) égale à 0 et présente comme premier tit (A1) la valeur ternaire "0" ou "+1", ou qui présente
   b) une somme de mot (WS) de +1 si le premier tit (A1) du mot ternaire est "0",

   la somme cumulée (LWS) de mots ternaires transmis (TWX) est dans le domaine -1, 0, +1 et, du côté du récepteur, après la reconversion des mots ternaires (TW) en mots de données binaires (DW), on répartit ces derniers en information utile (NI) et information auxiliaire (ZI).

2. Procédé selon la revendication 1, caractérisé en ce que l'on maintient la somme de mot cumulée (LWS) des mots ternaires transmis (TWX) dans le domaine de -1 à +1 par inversion des valeurs ternaires "-1" et "+1" d'un mot ternaire suivant ($TW_{k+1}$) qui présente une somme de mot WS = +1.

3. Procédé selon la revendication 1, caractérisé en ce que l'on maintient la somme de mot cumulée (LWS) dans le domaine 0,+1 par inversion des valeurs ternaires "+1" et "-1" du mot ternaire suivant ($TW_{k+1}$) qui présente une somme de mot WS = +1.

4. Procédé selon l'une quelconque des revendications précédentes, caractérisé en ce que

c) le mot ternaire (TW) ne présente pas plus de quatre valeurs ternaires intermédiaires "0" à la suite ou, ne présente pas au début et/ou à la fin du mot, plus de deux valeurs ternaires "0" à la suite.

5. Procédé selon la revendication 1 ou 2, caractérisé en ce que

    d) il n'apparaît pas deux valeurs ternaires successives +1, +1 ou -1, -1.

6. Procédé selon l'une quelconque des revendications précédentes, caractérisé en ce que, dans chaque mot ternaire (TW)

    e) le nombre des valeurs ternaires "+1" et "-1 dans un mot ternaire (TW) est supérieur à 2,
    f) il n'apparaît pas de suite de valeurs ternaires +1, 0, +1, 0, +1, ni de suite -1, 0, -1, 0, -1, et
    g) il n'apparaît pas au début du mot de suite +1, 0, +1, 0, ni -1, 0, -1, 0, ni de suite x, +1, 0, +1, 0, ni x, -1, 0, -1, 0 (x = -1, 0, +1).

7. Procédé selon l'une quelconque des revendications précédentes, caractérisé en ce qu'une inversion des valeurs ternaires "+1" et "-1" se produit lorsque la dernière valeur ternaire (A11, A12) différente de "0" du mot ternaire (TW$_K$) précédent et la première valeur ternaire (A1, A2, ...) différente de "0" du mot ternaire suivant (TW$_{K+1}$) présentent la même polarité.

8. Procédé selon la revendication 7, caractérisé en ce que l'on n'exploite toujours que la dernière valeur ternaire (A13) du mot ternaire (TW$_K$) précédent et la première valeur ternaire (A1) du mot ternaire suivant (TW$_{K+1}$).

9. Procédé selon l'une quelconque des revendications précédentes, caractérisé en ce que l'on empêche dans une large mesure des suites +1, 0, +1, 0 et -1, 0, -1, 0, ainsi que +1, 0, +1, x et -1, 0, -1, x à la fin des mots.

10. Dispositif de transmission d'information auxiliaire, caractérisé en ce qu'il est prévu, du côté de l'émetteur, un premier convertisseur série-parallèle (3), auquel est fournie l'information utile (NI) et qui fournit à sa sortie un mot de 12 bits qui est complété par un bit de l'information auxiliaire (ZI) pour former un mot de données (DW) à 13 bits,

    un convertisseur de code binaire-ternaire (4) convertit le mot de données à 13 bits (DW) en une composante positive à 12 bits (PA) et en une composante négative à 12 bits (NA) d'un mot ternaire (TW), lesquelles sont fournies à un circuit d'inversion (16) qui, en fonction d'une somme de mot cumulée (LWS), effectue une inversion de la composante positive (PA) et de la composante négative (NA),
    les composantes positives (PA) et les composantes négatives (NA) des mots ternaires à transmettre (TWX) sont introduites par l'intermédiaire d'un premier convertisseur parallèle-série (5) à un convertisseur binaire-ternaire (6) pour être converties en un signal ternaire (TS).

11. Dispositif de transmission d'information auxiliaire (ZI) par l'intermédiaire d'un canal de données ternaire, dans lequel une information utile (NI) à codage ternaire, qui est reconvertie du côté du récepteur en information utile (NI) binaire, est transmise, caractérisé en ce qu'il est prévu du côté du récepteur un convertisseur binaire-ternaire (9), auquel est délivré le signal ternaire (TS) et qui délivre à ses sorties des suites, correspondant à des états ternaires positifs et négatifs, de la composante positive (PA) et de la composante négative (NA),

    un deuxième convertisseur série-parallèle (10), qui convertit ces suites en composantes positives (PA) et composantes négatives (NA) présentes en parallèle du mot ternaire transmis (TWX), est prévu
    il est prévu un deuxième dispositif d'inversion (20), qui inverse en fonction des conditions d'inversion du côté émetteur les composantes positives (PA) et les composantes négatives (NA) et les envoie à un convertisseur de code ternaire-binaire (11), lequel délivre à ses sorties le mot de données 13 bits (DW) reconverti en binaire, qui est réparti en information utile (NI) et en information auxiliaire (ZI)

12. Dispositif selon la revendication 10, caractérisé en ce que, comme convertisseur de code ternaire-binaire (11), est prévu un circuit logique de sélection (21) , aux entrées duquel est introduit le même nombre de bits équivalents (P10, P11, P12; N10, N11, N12, A12) de la composante positive (PA) et de la composante négative (NA) d'un mot ternaire (TW) et dont les sorties activent chacune l'un parmi plusieurs (16) composants de mémorisation (31 à 46) dont les sorties équivalentes sont interconnectées.

FIG 1

## FIG 2

## FIG 3

# FIG 4